# EUROPEAN PATENT APPLICATION

(11) **EP 4 818 731 A1**
(43) Date of publication of application: **07.10.2026**
(21) Application number: 26167282.8
(22) Date of filing: 24.03.2026
(51) Int. Cl.: G01R 33/3815

(54) **SUPERCONDUCTING MAGNET AND MAGNETIC RESONANCE IMAGING APPARATUS**

(30) Priority: 01.04.2025 JP 2025060840; 20.02.2026 JP 2026026740
(71) Applicant: Canon Medical Systems Corporation, Otawara-shi, Tochigi 324-0036 (JP)
(72) Inventor: MIURA, Hideaki, Otawara-shi, 324-0036 (JP); KAWAMOTO, Hiromi, Otawara-shi, 324-0036 (JP)
(74) Representative: Marks & Clerk LLP

(57) **Abstract**

A superconducting magnet according to an embodiment includes a superconducting coil, a persistent current switch or a first switch, at least one of an external power supply and a load, a current lead, a second switch, and a control apparatus. The second switch is configured to include a first state and a second state, wherein the first state is a state in which the superconducting coil and the any one of the external power supply, the load, or both the external power supply and the load are electrically connected to each other, and the second state is a state in which electrical connection between the superconducting coil and the any one of the external power supply, the load, or both the external power supply and the load is cut off. The control apparatus is configured to switch the second switch between the first state and the second state.

## Description

### FIELD

Embodiments disclosed in the present specification and drawings relate to a superconducting magnet and a magnetic resonance imaging (MRI) apparatus.

### BACKGROUND

An MRI apparatus excites nuclear spins of a subject placed in a static magnetic field by a radio frequency (RF) pulse at the Larmor frequency, executes a scan that collects magnetic resonance (MR) signals generated from the subject due to the excitation, receives MR signals collected by the scan with an RF coil, and generates MR images based on the MR signals.

There are some MRI apparatuses in which a static magnetic field magnet that generates a static magnetic field is composed of a superconducting magnet. The superconducting magnet has a superconducting coil built therein, and the superconducting coil has hitherto been cooled to an extremely low temperature by liquid helium. For the superconducting coil cooled by liquid helium, a current lead made of copper is used, for example. The current lead made of copper is cooled by low-temperature helium gas obtained by evaporation of liquid helium, and hence enables the conduction of a current of several hundred amperes, for example. The current lead means a current-conduction conductor that electrically connects an external power supply (in other words, a static magnetic field power source) or an external load placed in a region under a normal temperature environment and the superconducting coil placed in a region under an ultra-low temperature environment.

In a superconducting magnet that does not use liquid helium or uses about several liters of helium for the cooling of the superconducting coil, high temperature superconductors (HTS) of which thermal conductivity is low and current-carrying capacity is large are often used as current leads in order to suppress heat ingress from the normal temperature region to the superconducting coil. When overcurrent conduction occurs in the current lead or the temperature of the current lead rises, there is a fear that the current lead may burn out.

### SUMMARY OF THE INVENTION

One of the problems to be solved by the embodiments disclosed in the present specification and the drawings is that a current lead used in a superconducting magnet can be protected. It should be noted, however, that possible problems to be solved by the embodiments disclosed in the present specification and the drawings are not limited to the problem presented above. It is also possible to regard problems corresponding to the advantageous effects achieved by the configurations described in the following embodiments as other problems.

A superconducting magnet according to an embodiment includes a superconducting coil, a persistent current switch or a first switch, at least one of an external power supply and a load, a current lead, a second switch, and a control apparatus. The superconducting coil is configured to generate a static magnetic field. The persistent current switch is electrically connected to the superconducting coil and is configured to perform switching between a superconducting state and a normal conduction state. The first switch is electrically connected to the superconducting coil and is configured to mechanically or electrically open and close an electric circuit. The external power supply is configured to supply current to the superconducting coil. The load is configured to dump magnetic energy of the superconducting coil. The current lead is configured to electrically connect the superconducting coil and any one of the external power supply, the load, or both the external power supply and the load to each other. The second switch is provided between the superconducting coil and the any one of the external power supply, the load, or both the external power supply and the load and is configured to include a first state and a second state, wherein the first state is a state in which the superconducting coil and the any one of the external power supply, the load, or both the external power supply and the load are electrically connected to each other, and the second state is a state in which electrical connection between the superconducting coil and the any one of the external power supply, the load, or both the external power supply and the load is cut off. The control apparatus is configured to switch the second switch between the first state and the second state.

The current lead may be configured to include a high-temperature superconducting material or phosphorous-deoxidized copper.

The control apparatus may be configured to switch the second switch between the first state and the second state based on an index relating to a temperature of the current lead.

The current lead may be include a first current lead and a second current lead, wherein the first current lead and the second current lead are electrically connected to both ends of the superconducting coil, respectively, a first circuit and a second circuit that electrically connect the first current lead and the second current lead to each other are electrically connected in parallel to each other, the first circuit includes the external power supply, the second circuit includes a third switch and a second load, the third switch includes an electrically connected state and an electrically open state, and the third switch and the second load are connected in series within the second circuit.

The control apparatus may be configured to place the second switch in the first state and place the third switch in an electrically open state in a process of supplying current to the superconducting coil.

The control apparatus may be configured to place the second switch in the second state and place the third switch in an electrically connected state after a process of supplying current to the superconducting coil is completed.

The superconducting magnet may further include at least one sensor, the at least one sensor being configured to measure a temperature of at least one of the current leads, wherein the index relating to the temperature of the current lead is the temperature of the current lead measured by the sensor.

The control apparatus may be configured to; place the second switch in the first state when the index relating to the temperature of the current lead is equal to or less than a first condition value, and place the second switch in the second state when the index relating to the temperature of the current lead is more than a second condition value, wherein the second condition value is equal to or more than the first condition value.

The superconducting magnet may further include at least one voltmeter, the at least one voltmeter being configured to measure a potential difference across at least one of the current leads, wherein the index relating to the temperature of the current lead is the temperature of the current lead estimated based on the potential difference.

The superconducting magnet may further include at least one voltmeter, wherein the at least one voltmeter is configured to measure a potential difference across at least one of the current leads, and the control apparatus is configured to switch the second switch between the first state and the second state based on an index relating to the potential difference across the current lead.

The control apparatus may be configured to; place the second switch in the first state when the index relating to the potential difference across the current lead is equal to or less than a first condition value, and place the second switch in the second state when the index relating to the potential difference across the current lead is more than a second condition value, wherein the second condition value is equal to or more than the first condition value.

The voltmeter may be configured to measure a potential difference across the current lead, the potential difference being a difference between a potential at an end portion of the current lead on a higher temperature side of the current lead and a potential at an end portion of the current lead on a lower temperature side of the current lead.

The second switch may be disposed on both ends of the any one of the external power supply, the load, or both the external power supply and the load.

The superconducting magnet further may include at least one resistor or at least one pair of bidirectionally disposed diodes electrically connected in parallel with the superconducting coil and the persistent current switch.

A magnetic resonance imaging apparatus according to one embodiment includes any of the superconducting magnets described above and a superconducting coil that generates a static magnetic field.

### BRIEF DESCRIPTION OF THE DRAWINGS

Fig. 1 is a block diagram illustrating an overall configuration example of an MRI apparatus according to an embodiment.
Fig. 2 is a block diagram illustrating an internal configuration example of a superconducting magnet according to a comparative example.
Fig. 3 is a block diagram illustrating an internal configuration example of a superconducting magnet according to a first embodiment.
Fig. 4A is a diagram for describing the concept of an excitation mode in the superconducting magnet according to the first embodiment.
Fig. 4B is a diagram for describing the concept of a current lead protection mode in the superconducting magnet according to the first embodiment.
Fig. 4C is a diagram for describing the concept of a persistent current mode in the superconducting magnet according to the first embodiment.
Fig. 5 is a flowchart illustrating an operation example of an MRI apparatus according to the first embodiment.
Fig. 6A is a diagram for describing the concept of the persistent current mode in the superconducting magnet according to the first embodiment.
Fig. 6B is a diagram for describing the concept of a demagnetization mode in the superconducting magnet according to the first embodiment.
Fig. 6C is a diagram for describing the concept of the current lead protection mode in the superconducting magnet according to the first embodiment.
Fig. 7 is a block diagram illustrating an internal configuration example of a superconducting magnet according to Modified Example 1 of the first embodiment.
Fig. 8 is a flowchart illustrating an operation example of an MRI apparatus according to Modified Example 1 of the first embodiment.
Fig. 9 is a block diagram illustrating an internal configuration example of a superconducting magnet according to Modified Example 2 of the first embodiment.
Fig. 10 is a flowchart illustrating an operation example of an MRI apparatus according to Modified Example 2 of the first embodiment.
Fig. 11 is a block diagram illustrating an internal configuration example of a superconducting magnet according to Modified Example 3 of the first embodiment.
Fig. 12 is a flowchart illustrating an operation example of an MRI apparatus according to Modified Example 3 of the first embodiment.
Fig. 13 is a block diagram illustrating an internal configuration example of a superconducting magnet according to a second embodiment.
Fig. 14A is a diagram for describing the concept of an excitation mode in the superconducting magnet according to the second embodiment.
Fig. 14B is a diagram for describing the concept of a current lead protection mode in the superconducting magnet according to the second embodiment.
Fig. 14C is a diagram for describing the concept of a persistent current mode in the superconducting magnet according to the second embodiment.
Fig. 15 is a flowchart illustrating an operation example of an MRI apparatus according to the second embodiment.
Fig. 16A to 16D are diagrams for describing switching of transitioning from the excitation mode to the persistent current mode in the superconducting magnet according to the second embodiment.
Fig. 17A is a diagram for describing the concept of the persistent current mode in the superconducting magnet according to the second embodiment.
Fig. 17B is a diagram for describing the concept of a demagnetization mode in the superconducting magnet according to the second embodiment
Fig. 17C is a diagram for describing the concept of the current lead protection mode in the superconducting magnet according to the second embodiment.

### DETAILED DESCRIPTION

The following will describe a superconducting magnet and an MRI apparatus according to embodiments, with reference to the accompanying drawings. In the drawings, some of the elements that are the same as each other will be referred to by using the same reference characters, and duplicate descriptions thereof will be omitted. Although an MRI apparatus 1 including a superconducting magnet 10 is illustrated below, the superconducting magnet 10 according to the embodiments may also be applied to apparatuses other than an MRI apparatus, such as an NMR apparatus.

### (An overall configuration of an MRI apparatus)

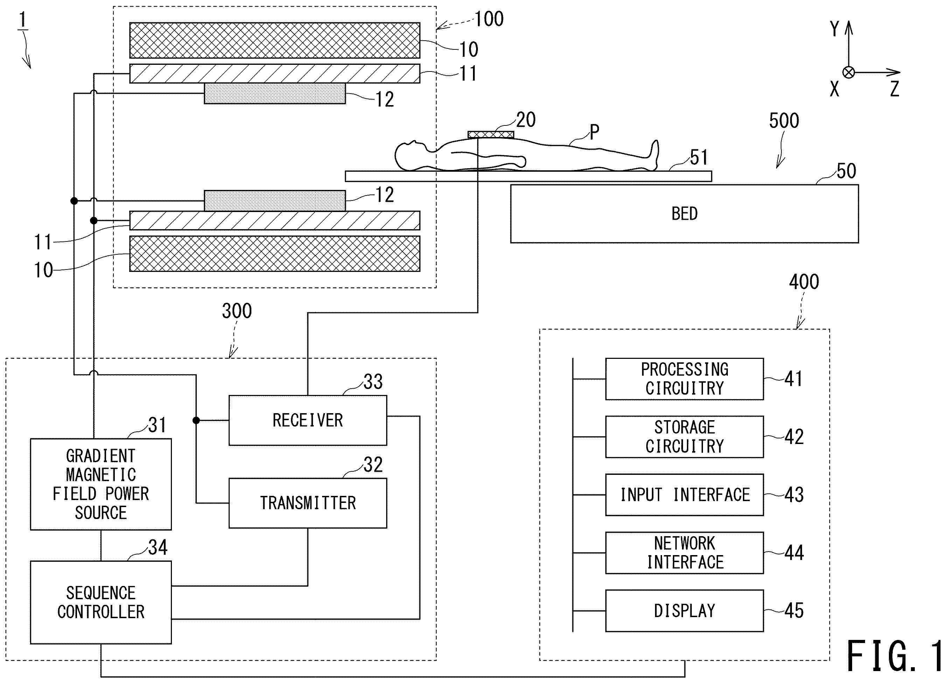

Fig. 1 is a block diagram illustrating an overall configuration example of an MRI apparatus 1 according to an embodiment. The MRI apparatus 1 includes a gantry apparatus 100, a control cabinet 300, a console 400, and a table 500. Generally, the gantry apparatus 100 and the table 500 are arranged in an imaging room where a magnetic field is generated, the control cabinet 300 is arranged in a machine room, and the console 400 is arranged in an operation room where a user operates the console 400. The console 400 may be arranged in a hospital or a remote location such as outside the hospital via a network.

The gantry apparatus 100 includes a superconducting magnet 10, a gradient magnetic field coil 11, and a Whole Body (WB) coil 12. These constituent elements are housed in a circular cylindrical casing.

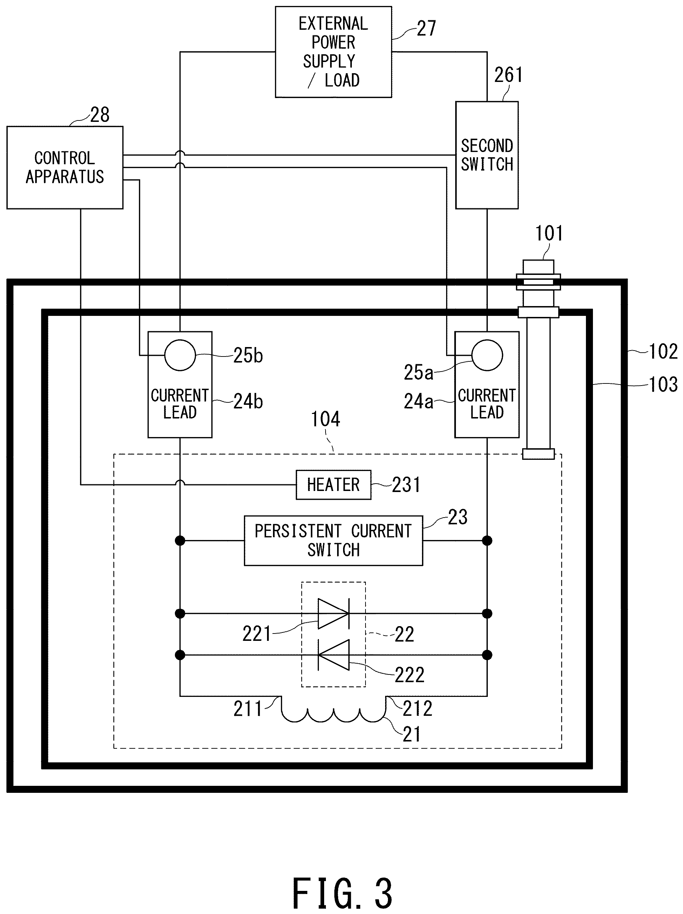

The superconducting magnet 10 has a substantially cylindrical shape and generates a static magnetic field in an imaging region in a bore into which a patient that is a subject P is moved. The bore is an examination space inside the cylinder of the superconducting magnet 10. The superconducting magnet 10 has a superconducting coil 21 (see Fig. 3) built therein. The superconducting coil 21 is a coil obtained by winding superconducting wire. The superconducting magnet 10 is cooled to a temperature at which a superconducting state is obtained, and stably generates a static magnetic field without current supply from a place outside the magnet. The superconducting magnet 10 may be a superconducting magnet immersed in liquid helium and other refrigerant, a thermosyphon-type superconducting coil that cools the superconducting coil 21 by circulating refrigerant in a pipe, or a conduction-cooled superconducting magnet that performs cooling by a heat transfer path from a refrigeration machine using almost no refrigerant. The type of the superconducting wire material used in the superconducting magnet is not limited, and low-temperature superconducting wire materials as represented by niobium-titanium and niobium-tin or high-temperature superconducting wire materials as represented by a copper-oxide superconducting material (REBCO), Bi-based materials (Bi-2212, Bi-2223, and the like), and MgB₂ may be used.

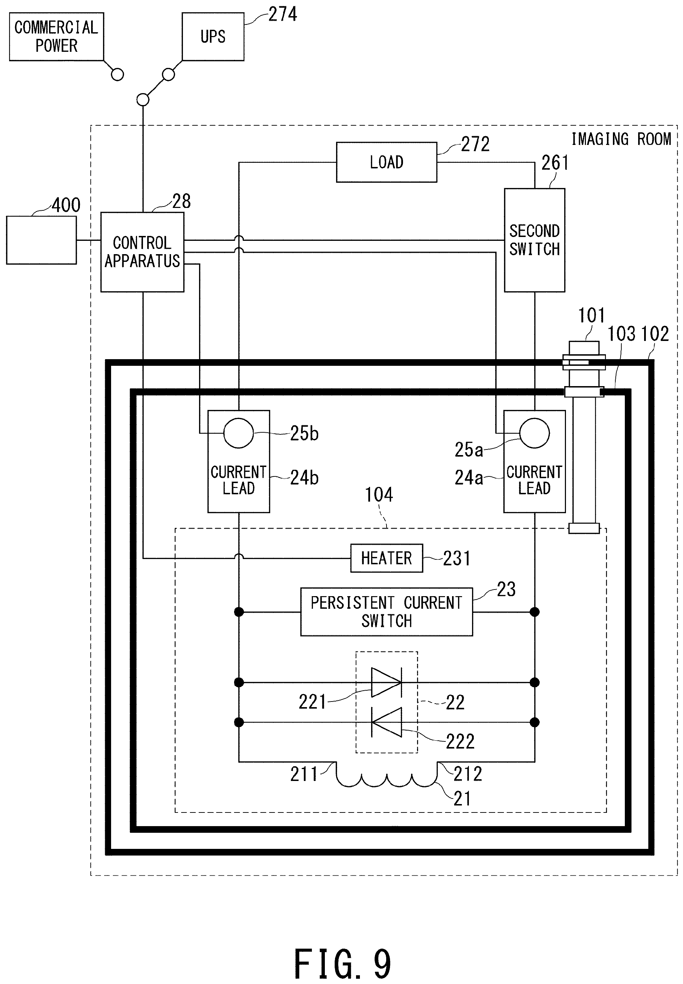

An emergency power supply that enables demagnetization of the static magnetic field or an uninterruptible power supply (UPS) 274 (see Fig. 9) activated at the time of power outage may be provided in preparation for an emergency such as the quench of the superconducting coil. The superconducting magnet 10 is described in detail later. The quench is a phenomenon in which a superconducting substance such as a superconducting coil transitions from a superconducting state to a normal conduction state.

The gradient magnetic field coil 11 has a substantially cylindrical shape, and is fixed to the inner side of the superconducting magnet 10 for static magnetic field generation in the radial direction of the cylindrical shape. The gradient magnetic field coil 11 receives supply of current from the gradient magnetic field power supply 31 and generates a gradient magnetic field. The gradient magnetic field coil 11 has coils that generate magnetic fields corresponding to axes of an X-axis, a Y-axis, and a Z-axis orthogonal to each other incorporated therein, and the coils for the axes individually receive supply of current from the gradient magnetic field power supply 31, superimpose magnetic fields corresponding to the axes of the X-axis, the Y-axis, and the Z-axis onto the static magnetic field, and generate a gradient magnetic field.

Here, the Z-axis direction is a direction set along the magnetic flux of the static magnetic field generated by the superconducting magnet 10, and is the same direction as the longitudinal direction of the tabletop 51. The Y-axis direction is a vertical direction perpendicular to the Z-axis direction, and is a direction perpendicular to the tabletop 51. The X-axis direction is a direction perpendicular to both the Z-axis and the Y-axis, and is the same direction as the short-side direction of the tabletop 51. The X axis, the Y axis, and the Z axis are orthogonal to one another.

The WB coil 12 is an RF coil that has a substantially circular cylindrical shape and is fixed to the inside of the gradient magnetic field coil 11 so as to surround the subject. The WB coil 12 transmits, to the subject P, an RF pulse transferred thereto from a transmitter 32 and receives an MR signal emitted from the subject P in response to excitation of a hydrogen atomic nucleus.

The MRI apparatus 1 may have a local coil 20 in addition to the WB coil 12. The local coil 20 is an RF coil disposed in proximity to the subject P and receives an MR signal emitted from the subject P in a position close to the subject P. The local coil 20 may transmit an RF pulse transmitted from the transmitter 32 to the subject P. There are various types of local coils 20 corresponding to imaging sites of the subject P, such as the head, the chest, (e.g., Fig. 1), the spine, a leg, and the whole body.

The control cabinet 300 includes the gradient magnetic field power source 31, the transmitter 32, a receiver 33, and a sequence controller 34.

The gradient magnetic field power source 31 causes the gradient magnetic field coil 11 to generate the gradient magnetic field formed along the axes, namely, the X axis, the Y axis, and the Z axis, by supplying the current thereto, under control of the sequence controller 34.

The transmitter 32 generates an RF pulse in the Larmor-frequency band as an RF transmission wave on the basis of an instruction signal from the sequence controller 34, and outputs the RF transmission wave to the RF coil to excite the subject P.

The receiver 33 performs an Analog-Digital (AD: Analog-to-Digital) conversion the MR signal received by the RF coil and outputs the converted result to the sequence controller 34. The digitalized MR signal will be referred to as raw data.

Under control of the console 400, the sequence controller 34 executes a scan of the subject P, by driving the gradient magnetic field power source 31, the transmitter 32, and the receiver 33. The sequence controller 34 receives the raw data via the receiver 33 and transmits the received raw data to the console 400.

The sequence controller 34 is provided with processing circuitry (not shown). The processing circuitry of the sequence controller 34 is configured, for example, with a processor that executes a predetermined program or hardware such as a Field Programmable Gate Array (FPGA) or an Application Specific Integrated Circuit (ASIC).

The table 500 includes a bed 50 and a tabletop 51. The bed 50 is capable of moving the tabletop 51 in up-and-down directions and horizontal directions. The subject P placed on the tabletop 51 is moved to a prescribed height and is further moved into the bore.

The console 400 includes processing circuitry 41, storage circuitry 42, an input interface 43, a network interface 44, and a display 45. The console 400 is an image processing apparatus configured by a computer.

The processing circuitry 41 controls the entire MRI apparatus 1. The processing circuitry 41 is a processor that realizes various functions by reading and executing various processing programs that are stored in the storage circuitry 42 or directly incorporated in the processing circuitry 41.

The storage circuitry 42 is a processor-readable recording medium such as a semiconductor memory element, a random access memory (RAM), a flash memory, a hard disk, an optical disk device, for example. The storage circuitry 42 may also be a portable medium such as a universal serial bus (USB) memory or a digital versatile disk (DVD). The storage circuitry 42 stores therein various types of information and data and stores therein various types of programs to be executed by the processor included in the processing circuitry 41.

The input interface 43 includes: various types of input devices used by a user such as a medical technologist for inputting various types of information and data; and input circuitry that processes signals received from the input devices. The input devices may be, for example, a trackball, a switch, a mouse, a keyboard, a touchpad that performs input operations by touching the scanning surface, a touchscreen that combines a display screen and a touchpad, a non-contact input device that uses an optical sensor, and a voice input device. When any of the input devices is operated, the input circuitry generates an instruction signal corresponding to the operation and outputs the generated instruction signal to the processing circuitry 41.

The network interface 44 implements various information communication protocols according to the type of network. The network interface 44 controls communication according to the various protocols, communicates with various types of apparatuses connected to the network in a wired or wireless manner, so as to exchange various type of information and data.

The display 45 is a display device such as a liquid crystal display panel, a plasma display panel, or an organic Electroluminescence (EL) panel. The display 45 displays various types of information and data under the control of the processing circuitry 41. The display 45 may be a Graphical User Interface (GUI) that displays various types of information and data and also functions as an input device.

By employing these constituent elements, the console 400 controls the entirety of the MRI apparatus 1. More specifically, the processing circuitry 41 receives an instruction related to imaging conditions, through an operation performed by the user via the input interface 43. After that, the processing circuitry 41 causes the sequence controller 34 to execute the scan based on the input imaging conditions. Further, the processing circuitry 41 reconstructs an MR image based on the raw data transmitted thereto from the sequence controller 34. The reconstructed MR image is displayed on the display 45 and saved in the storage circuitry 42.

As described above, in the superconducting magnet, a high temperature superconductor of which thermal conductivity is low and current-carrying capacity is large, for example, is used as the current lead in order to suppress heat ingress from the normal temperature region to the superconducting coil. When overcurrent conduction occurs in the current lead or the temperature of the current lead rises, there is a fear that the current lead may burn out.

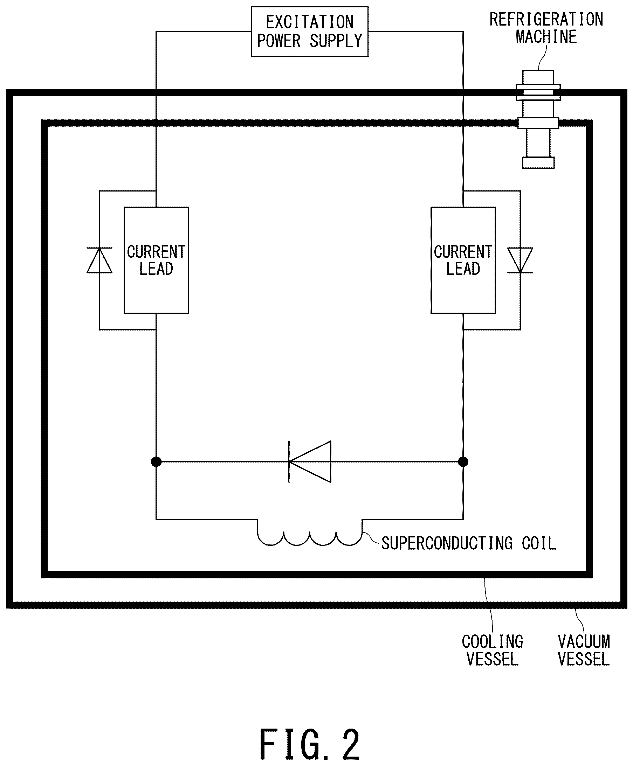

Here, Fig. 2 is a block diagram illustrating an internal configuration example of a superconducting magnet according to a comparative example. In the comparative example, a diode that is a protection element is connected in parallel to current lead that is a superconductor. Therefore, when the current lead transitions to a high resistance state due to the temperature rise of the superconducting magnet, the current flowing through the current lead flows by being bypassed to the diode. As a result, the burnout of the current lead is prevented.

However, when the diode is connected in parallel to the current lead, it is assumed that the heat ingress amount from the diode to the extremely low temperature region increases, and there is a fear that bodies to be cooled such as the superconducting coil may not drop to a desired temperature. The ON-state voltage of the diode increases at low temperature, and hence there is a fear that it may take time for the current to flow by being bypassed to the diode and the burnout of the current lead may not be preventable.

Thus, the superconducting magnet 10 according to the embodiments suppresses heat ingress from the outside to the extremely low temperature region and protects the current lead by having control for cutting off the current flowing through the current lead.

### (First Embodiment)

Fig. 3 is a block diagram illustrating an internal configuration example of the superconducting magnet 10 according to a first embodiment. The MRI apparatus 1 includes the superconducting magnet 10, a cooling vessel 103 that accommodates the superconducting magnet 10, a vacuum vessel 102 that accommodates the cooling vessel 103, and a refrigeration machine 101 attached to the vacuum vessel 102. The refrigeration machine 101 may be a two-stage refrigeration machine, for example, and has a first cooling stage and a second cooling stage 104 that is lower than the first cooling stage in temperature. For example, the temperature of the first cooling stage is about 40 kelvin, and the temperature of the second cooling stage is about 4 kelvin. The cooling vessel 103 includes a heat radiation shield plate made of aluminum, for example, and is also referred to as a radiation shield.

The superconducting magnet 10 includes the superconducting coil 21, a protection diode unit 22, a persistent current switch 23, current leads 24a and 24b, a second switch 261, an external power supply-load unit 27, and a control apparatus 28. The external power supply-load unit 27 is any one of "an external power supply, a load, or both the external power supply and the load".

In Fig. 3, a case in which the two current leads 24a and 24b are respectively connected to both ends of the superconducting coil 21 is illustrated. A case of the two current leads 24a and 24b is described below, but the number of the current leads is not limited, and one or a plurality of current leads may be connected, the current leads may be connected to only one end of the superconducting coil 21, or a different number of current leads may be connected to each end of the superconducting coil 21.

The superconducting coil 21, the protection diode unit 22, and the persistent current switch 23 are housed in the vacuum vessel 102 to be cooled to an extremely low temperature. The vacuum vessel 102 prevents heat ingress and is referred to as a cryostat. The two current leads 24a and 24b may be disposed on the inside of the vacuum vessel 102 and on the inner side, the outer side, or the inside and outside of the cooling vessel 103 so as to be connected to the cooling vessel 103, but is preferably disposed on the inner side of the cooling vessel 103. The temperature of each of the two current leads 24a and 24b becomes lower at a part closer to the superconducting coil than a part farther from the superconducting coil.

Fig. 3 is an example of an equivalent circuit diagram illustrating of an electrical connection relationship of the superconducting magnet 10. The superconducting coil 21 generates a static magnetic field. The superconducting coil 21 is electrically connected to the external power supply-load unit 27 via the two current leads 24a and 24b.

In Fig. 3, one superconducting coil 21 is schematically illustrated, but the superconducting coil 21 may be composed of a plurality of superconducting coils. When the superconducting coil 21 is composed of a plurality of superconducting coils, all of the superconducting coils may be electrically connected in series, all of the superconducting coils may be electrically connected in parallel, or a circuit configuration in which the superconducting coils are electrically connected in combination of series connection and parallel connection may be employed.

The persistent current switch 23 is electrically connected in parallel to the superconducting coil 21, in other words, between a current input end 211 and a current output end 212 of the superconducting coil 21. The persistent current switch 23 is electrically connected in parallel to the external power supply-load unit 27. The persistent current switch 23 may be a first switch that mechanically or electrically switches the connection of an electric circuit. The first switch may be a mechanical switch or a semiconductor switch that turns the current ON and OFF.

The persistent current switch 23 performs switching between a superconducting state (closed circuit state) and a normal conduction state (open circuit state). The persistent current switch 23 is configured to include a superconducting member and a heater 231 arranged in close proximity to the superconducting member, for example. When the heater 231 is OFF, the persistent current switch 23 is placed in a closed circuit state, and the superconducting member is maintained at a superconducting state. When the heater 231 is ON, the superconducting member is placed in a normal conduction state, and hence the persistent current switch 23 is placed in an open circuit state. The persistent current switch 23 configured to include the superconducting member and the heater 231 arranged in close proximity to the superconducting member fulfills a switching function in accordance with the presence of an electrical resistance and is electrically connected to both ends of the persistent current switch 23 even in an open circuit state.

The control apparatus 28 includes a processor that executes a predetermined program and hardware such as an FPGA and an ASIC, for example. The control apparatus 28 performs control for switching the persistent current switch 23 between a superconducting state (closed circuit state) and a normal conduction state (open circuit state). The control apparatus 28 performs control relating to opening and closing of a first switch. Specifically, the control apparatus 28 performs control of turning the heater 231 ON and OFF, and the heater 231 is heated when the heater 231 is ON.

The protection diode unit 22 is electrically connected to the superconducting coil 21 and the persistent current switch 23 in parallel thereto, and protects the superconducting coil 21 and the persistent current switch 23. The protection diode unit 22 includes at least one pair of diodes 221 and 222 bidirectionally disposed, for example. As a result of one pair of diodes 221 and 222 being bidirectionally disposed, the superconducting coil 21 and the persistent current switch 23 can be protected in both processes of an excitation process and a demagnetization process and at the time of unexpected quench of the superconducting coil and the persistent current switch.

Here, the excitation process means a process of generating a magnetic field by causing current supplied by the static magnetic field power source to flow through the superconducting coil 21, and the demagnetization process means a process of dumping, in other words, consuming, the magnetic energy of the superconducting coil 21 and reducing the magnetic field generated by the superconducting coil 21 by causing current to flow through a load, in other words, a demagnetizing load. In the demagnetization process, the static magnetic field power source may be electrically connected to or disconnected from the superconducting coil 21. The protection diode unit 22 may be composed of a resistor or may be composed of a mixture of a resistor and a diode.

The external power supply-load unit 27 is electrically connected to the two current leads 24a and 24b. As described above, the external power supply-load unit 27 is configured to include at least one of a static magnetic field power source 271 and a load 272. The static magnetic field power source 271 supplies current to the superconducting coil 21 in the excitation process, in other words, an excitation mode. The load dumps, in other words, consumes, the magnetic energy of the superconducting coil 21 and reduces the magnetic field generated by the superconducting coil 21 in the demagnetization process, in other words, a demagnetization mode. A resistor or a diode is used as the load to convert electrical energy to thermal energy, for example.

The second switch 261 is electrically connected to the superconducting coil 21. The second switch 261 is provided between the external power supply-load unit 27 and at least one of the current lead 24a or 24b and turns the current between the external power supply-load unit 27 and the superconducting coil 21 ON and OFF. The second switch 261 has a first state in which the external power supply-load unit 27 and the superconducting coil 21 are electrically connected to each other and a second state in which the electrical connection between the external power supply-load unit 27 and the superconducting coil 21 is cut off. Regarding the second switch 261, the first state is also referred to as a closed circuit state, and the second state is also referred to as an open circuit state.

The second switch 261 mechanically or electrically switches the connection of an electric circuit. The second switch 261 may be a mechanical switch or may be a semiconductor switch that turns the current ON and OFF, but is preferably a solid state relay (SSR) that uses a semiconductor switching element. The SSR is a contactless relay and enables stable operation as the second switch 261 even under a magnetic field in an imaging room. However, in general, the SSR tends to easily generate heat because the ON-resistance at the time of current conduction is larger as compared to a mechanical relay, and the SSR is desired to have a heat removal structure.

Thus, for example, the SSR may be disposed so as to be in contact with the vacuum vessel 102 made of metal. As a result, the heat generated by the SSR is transmitted to the vacuum vessel 102 and is efficiently removed. For example, a heat sink including at least one or more fins may be disposed adjacent to the SSR. The release of the heat generated by the SSR is facilitated by the heat sink. Heat removal is efficiently performed by thermally connecting the vacuum vessel 102 or the heat sink to the SSR as above.

It is only necessary to dispose of at least one second switch 261. Although one second switch 261 is provided between the external power supply-load unit 27 and the current lead 24a in Fig. 3, the second switch 261 may be provided on both ends of the external power supply-load unit 27.

The two current leads 24a and 24b electrically connect the external power supply-load unit 27 and the superconducting coil 21 to each other. One of the two current leads 24a and 24b is provided between one end of the superconducting coil 21 and one end of the external power supply-load unit 27. The other of the two current leads 24a and 24b is provided between the other end of the superconducting coil 21 and the other end of the external power supply-load unit 27. In general, parts of the current leads 24a and 24b close to the superconducting coil 21 are lower in temperature than parts of the current leads 24a and 24b far from the superconducting coil 21.

It is preferred that the current leads 24a and 24b may be composed of a material with low thermal conductivity and having electrical conductivity. The current leads 24a and 24b are composed of high-temperature superconducting materials such as MgB₂, REBCO, and Bi-based materials or phosphorous-deoxidized copper, for example.

In the first embodiment, the MRI apparatus 1 includes at least one of temperature sensors 25a and 25b that measures the temperature of at least one of the current leads 24a and 24b. The temperatures of the current leads 24a and 24b are an index relating to the temperature of the current lead.

In Fig. 3, one of the temperature sensors 25a and 25b is provided for each of the two current leads 24a and 24b, but it is possible to include one temperature sensor in only either one of the two current leads 24a and 24b, or a plurality of the temperature sensors 25a and 25b may be included in the current leads 24a and 24b. The temperature sensors may be disposed on both ends of each of the current leads. When two temperature sensors are disposed on both ends of each of the current leads 24a and 24b, in other words, one current lead, it becomes possible to measure a part with low temperature and a part with high temperature in each of the current leads 24a and 24b. Therefore, the index relating to the temperature of the current lead can be acquired with more precision.

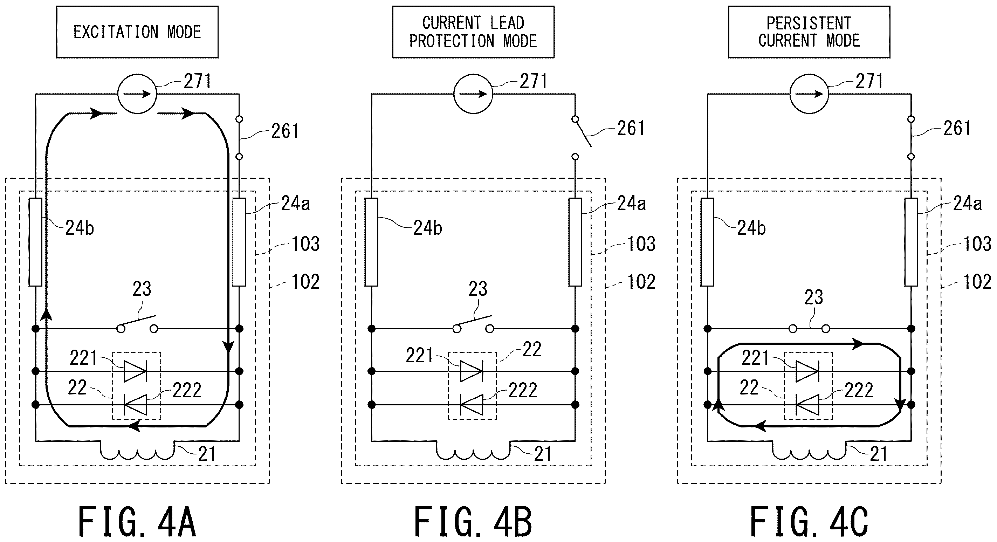

Fig. 4A to Fig. 4C are diagrams for describing the concept of three operation modes in the superconducting magnet 10. Fig. 4A is a diagram illustrating an operation example of an excitation mode. The excitation mode is an operation mode for generating a static magnetic field with a predetermined strength in the superconducting magnet 10 by connecting the static magnetic field power source 271 and supplying current to the superconducting magnet 10 that is not generating a static magnetic field, in other words, the superconducting coil 21 that is not operating.

In the excitation mode, the heater 231 of the persistent current switch 23 is controlled by the control apparatus 28 to be turned ON. As a result, the persistent current switch 23 is placed in a normal conduction state (open circuit state). In the excitation mode, the excitation current supplied from the static magnetic field power source 271 flows in a current loop of the current lead 24a, the superconducting coil 21, and the current lead 24b. When the excitation current gradually increases from zero and reaches a rated value, the excitation mode transitions to a persistent current mode.

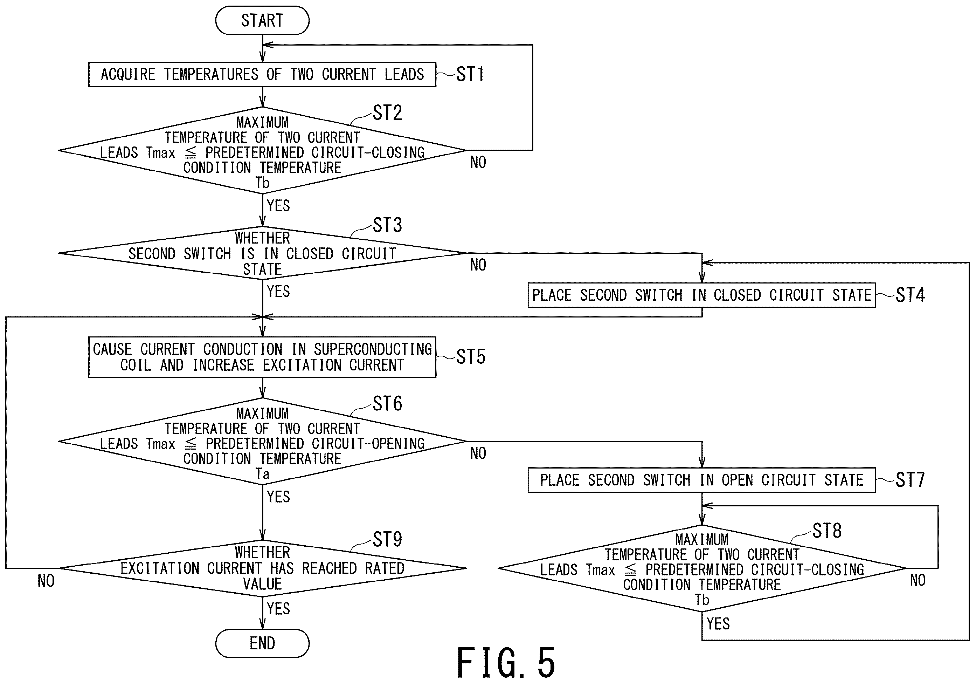

With reference to the flowchart in Fig. 5 and Fig. 4B, an operation example of a current lead protection mode in the excitation process is described.

In Step ST1, the control apparatus 28 acquires the temperatures of the two current leads 24a and 24b. The temperatures of the two current leads 24a and 24b are monitored for a predetermined amount of time or continuously, and determination relating to the temperatures of the two current leads 24a and 24b in Steps ST2, ST6, and ST8 is enabled.

In Step ST2, the control apparatus 28 determines whether a maximum temperature Tmax that is the higher temperature out of the temperatures of the two current leads 24a and 24b is equal to or less than a predetermined circuit-closing condition temperature Tb, for example. The circuit-closing condition temperature Tb is a temperature at which the circuit cut off in order to protect the current lead is re-established, in other words, the second switch 261 is caused to form a closed circuit. The circuit-closing condition temperature Tb is one example of a first condition value relating to the opening and closing of the second switch. The first condition value only needs to be a condition value relating to temperature, and may be a condition value of temperature or may be a condition value of a temperature change amount. When maximum temperature Tmax > circuit-closing condition temperature Tb is satisfied, in other words, when the determination is NO, the processing proceeds to Step ST1. In Step ST1, there is no current conduction in the superconducting coil 21. When maximum temperature Tmax ≤ circuit-closing condition temperature Tb is satisfied, in other words, when the determination is YES, the processing proceeds to Step ST3.

In Step ST3, the control apparatus 28 determines whether the second switch 261 is in a closed circuit state. When the second switch 261 is in a closed circuit state, in other words, when the determination is YES, the processing proceeds to Step ST5. When the second switch 261 is in an open circuit state, in other words, when the determination is NO, the processing proceeds to Step ST4. In Step ST4, the control apparatus 28 performs control for placing the second switch 261 in a closed circuit state.

In Step ST5, the control apparatus 28 causes current conduction in the superconducting coil 21 and increases the excitation current. In Step ST6, the control apparatus 28 determines whether the maximum temperature Tmax that is the higher temperature out of the temperatures of the two current leads 24a and 24b is equal to or less than a predetermined circuit-opening condition temperature Ta. The circuit-opening condition temperature Ta is a temperature at which the circuit is cut off in order to protect the current lead, in other words, a temperature at which the second switch 261 is caused to form an open circuit. The circuit-opening condition temperature Ta is one example of a second condition value relating to the opening and closing of the second switch 261. The second condition value only needs to be a condition value relating to temperature, and may be a condition value of temperature or may be a condition value of a temperature change amount.

Here, the second condition value is the same value as the first condition value or a value greater than the first condition value. In general, the current lead gradually changes in temperature in accordance with current conduction. Thus, when the temperature of the current lead is on a rising trend, the control apparatus 28 causes the second switch 261 to form an open circuit when the temperature of the current lead exceeds the second condition value. When the temperature of the current lead is on a downward trend, the control apparatus 28 causes the second switch 261 to form a closed circuit when the first condition value smaller than the second condition value falls below the temperature of the current lead. The hunting phenomenon of the second switch 261 can be prevented and the burnout of the current leads 24a and 24b can be prevented by providing hysteresis characteristics based on the state of the temperature change of the current leads in the control of the second switch 261 by the control apparatus 28 as above.

When maximum temperature Tmax > circuit-opening condition temperature Ta is satisfied, in other words, when the determination is NO, the processing proceeds to Step ST7. When maximum temperature Tmax ≤ circuit-opening condition temperature Ta is satisfied, in other words, when the determination is YES, the processing proceeds to Step ST9.

In Step ST7, the control apparatus 28 places the second switch 261 in an open circuit state. Here, Fig. 4B is a diagram illustrating an operation example of the current lead protection mode in the excitation process. When the second switch 261 is placed in an open circuit state, the current that flows through the two current leads 24a and 24b becomes zero. Even when a current loop is formed by the superconducting coil 21 and the persistent current switch 23 (the persistent current mode illustrated in Fig. 4C), the current that flows through the two current leads 24a and 24b becomes zero. As a result of the current that flows through the current leads 24a and 24b becoming zero, the temperatures of the current leads 24a and 24b are placed in a reduced state. As a result, the burnout of the current leads 24a and 24b can be prevented.

In Step ST8, the control apparatus 28 determines whether the maximum temperature Tmax that is the higher temperature out of the temperatures of the two current leads 24a and 24b is equal to or less than a predetermined circuit-closing condition temperature Tb. As described above, the circuit-closing condition temperature Tb is a temperature at which the circuit cut off in order to protect the current lead is re-established and is one example of the first condition value relating to the opening and closing of the second switch. When maximum temperature of two current leads Tmax > circuit-closing condition temperature Tb is satisfied, in other words, when the determination is NO, the processing in Step ST8 is repeated.

When maximum temperature of two current leads Tmax ≤ circuit-closing condition temperature Tb is satisfied, in other words, when the determination is YES, the processing proceeds to Step ST4. When it is determined that the temperatures of the two current leads 24a and 24b have sufficiently decreased, the second switch 261 is placed in a closed circuit state.

In Step ST9, the control apparatus 28 determines whether the excitation current has reached a rated value, in other words, a rated current. When the rated current is reached, in other words, when the determination is YES, the processing ends. In other words, when the excitation is completed, transition to the persistent current mode is performed. When the rated current is not reached, in other words, when the determination is NO, the processing proceeds to Step ST5.

Fig. 4C is a diagram illustrating an operation example of the persistent current mode. When the excitation current reaches the rated value, the heater 231 of the persistent current switch 23 is turned OFF by the control apparatus 28. By turning OFF the heater 231, the superconducting member included in the persistent current switch 23 is cooled, the normal conduction state transitions to the superconducting state, and the persistent current switch 23 is placed in a superconducting state (closed circuit state).

As a result, a persistent current loop is formed by the persistent current switch 23 and the superconducting coil 21, and persistent current flows through the superconducting coil 21. Both the superconducting coil 21 and the persistent current switch 23 are in a superconducting state, and the electrical resistance is zero. Therefore, even when the static magnetic field power supply 271 is removed from the superconducting magnet 10, a persistent current mode in which the persistent current maintains a persistent current loop is obtained. In this case, the second switch 261 may be placed in a closed circuit state or may be placed in an open circuit state.

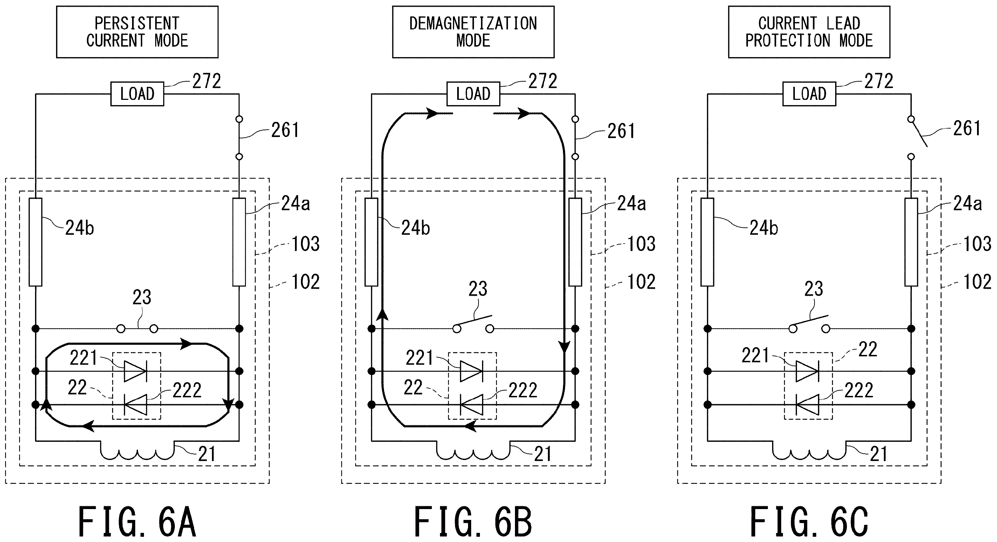

Fig. 6A to Fig. 6C are diagrams for describing the concept of three operation modes in the superconducting magnet 10. Fig. 6A is a diagram illustrating an operation example of the persistent current mode. Fig. 6A is the same as Fig. 4C other than a feature in which the load 272 is electrically connected as the external power supply-load unit 27 instead of the static magnetic field power source 271.

Fig. 6B is a diagram illustrating an operation example of a demagnetization mode. The demagnetization mode is an operation mode for reducing the magnetic field generated by the superconducting magnet 10 by connecting a load to the superconducting magnet 10 generating a static magnetic field, in other words, the superconducting coil 21 in operation and by converting the magnetic energy of the superconducting coil to thermal energy.

In the demagnetization mode, the heater 231 of the persistent current switch 23 is controlled by the control apparatus 28 to be turned ON. As a result, in the demagnetization mode in which the persistent current switch 23 is placed in an open circuit state, demagnetizing current of which power source is magnetic energy accumulated in the superconducting coil 21 flows in a current loop of the current lead 24b, the load 272, and the current lead 24a. Electric power by magnetic energy accumulated in the superconducting coil 21 is consumed by the load 272, and the magnetic field generated by the superconducting magnet 10 is reduced.

Fig. 6C is a diagram illustrating an operation example of the current lead protection mode in the demagnetization process. The MRI apparatus 1 performs an operation similar to that in the flowchart in Fig. 5 in the demagnetization process as well. When the second switch 261 is placed in an open circuit state, the current that flows through the two current leads 24a and 24b becomes zero. Even when a current loop is formed by the superconducting coil 21 and the persistent current switch 23, the current that flows through the two current leads 24a and 24b becomes zero. As a result of the current that flows through the current leads 24a and 24b becoming zero, the temperatures of the current leads 24a and 24b are placed in a reduced state. As a result, burnout can be prevented.

In other words, the control apparatus 28 performs control for placing the second switch 261 in an open circuit state or a closed circuit state on the basis of the index relating to the temperatures of the current leads 24a and 24b monitored by the control apparatus 28. Specifically, the control apparatus 28 places the second switch 261 in an open circuit state or a closed circuit state on the basis of either the temperatures of the current leads 24a and 24b measured by the temperature sensors 25a and 25b or the temperature change amounts calculated from the measured temperatures of the current leads 24a and 24b.

### (Modified Example 1 of First Embodiment)

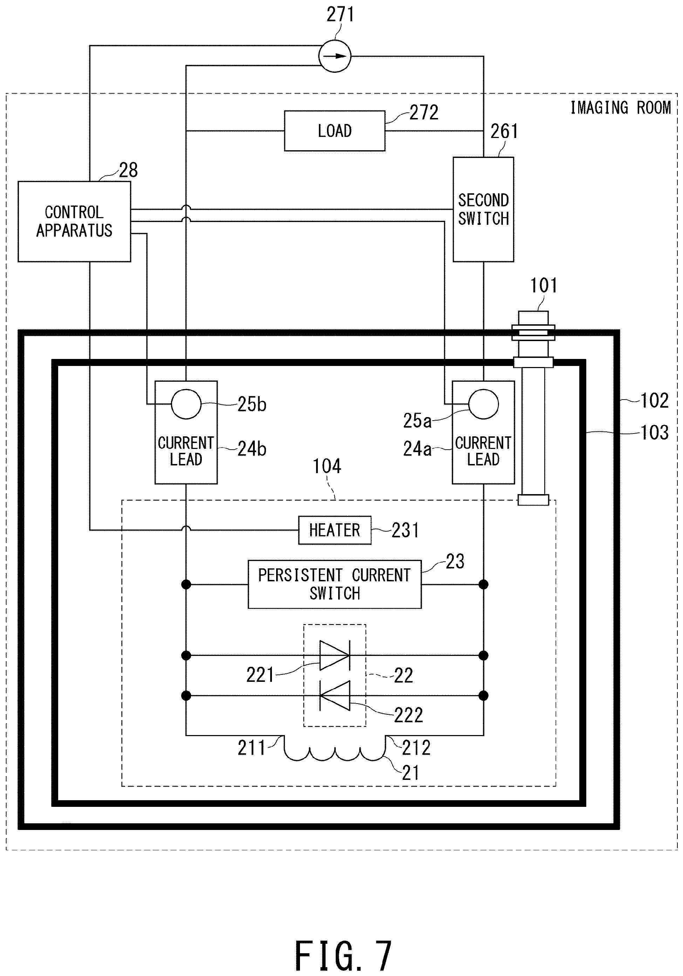

Fig. 7 is a block diagram illustrating an internal configuration example of the superconducting magnet 10 according to Modified Example 1 of the first embodiment. In Modified Example 1 of the first embodiment, the second switch 261 is an SSR. The static magnetic field power source 271 and the load 272 are in a state of being electrically connected to the superconducting coil 21. Modified Example 1 of the first embodiment is different from the first embodiment in that the control apparatus 28 places the SSR in a closed circuit state immediately before the current caused to flow through the superconducting coil 21 is increased or reduced for excitation or demagnetization (or degaussing), and places the SSR in an open circuit state when the superconducting coil 21 quenches during excitation or degaussing in Modified Example 1 of the first embodiment.

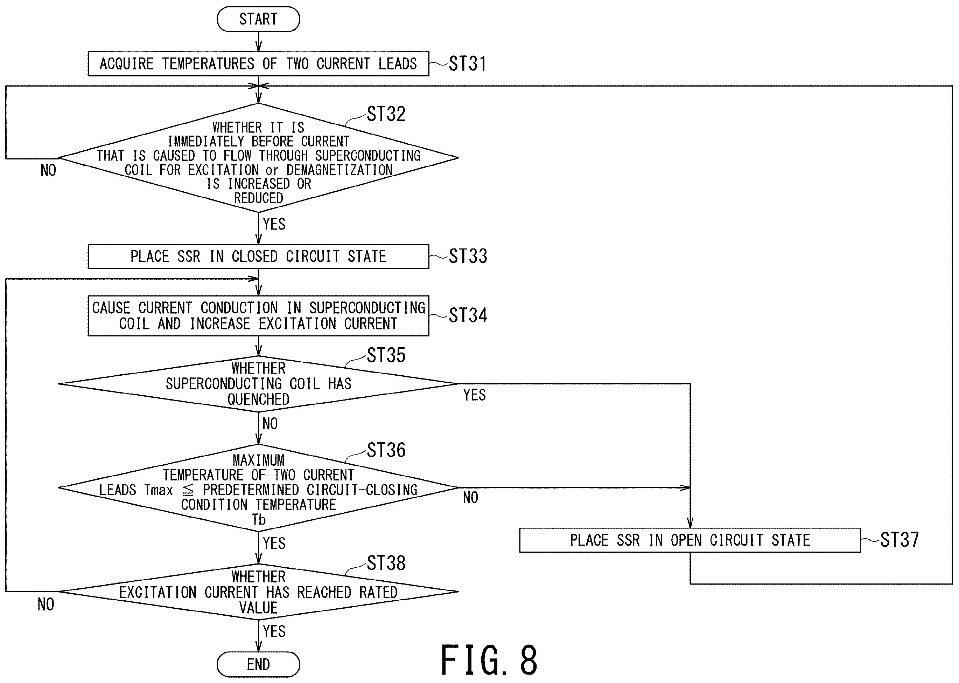

With reference to the flowchart in Fig. 8, an operation example of the MRI apparatus 1 according to Modified Example 1 of the first embodiment is described.

In Step ST31, the control apparatus 28 acquires the temperatures of the two current leads 24a and 24b. The temperatures of the two current leads 24a and 24b are monitored for a predetermined amount of time or continuously, and determination relating to the temperatures of the two current leads 24a and 24b in Step ST36 is enabled. In Step ST31, there is no current conduction in the superconducting coil 21.

In Step ST32, the control apparatus 28 determines whether it is immediately before the current that is caused to flow through the superconducting coil 21 for the excitation or the demagnetization (or degaussing) is increased or reduced. When it is determined that it is immediately before the current caused to flow through the superconducting coil for excitation or degaussing is increased or reduced by the control apparatus 28 in Step ST32, in other words, when the determination is YES, the processing proceeds to Step ST33.

In Step ST33, the control apparatus 28 performs control for placing the SSR that is the second switch 261 in a closed circuit state. In Step ST34, the control apparatus 28 causes current conduction in the superconducting coil 21 and increases or decreases the excitation current.

In Step ST35, the control apparatus 28 determines whether the superconducting coil 21 has quenched. In Step ST35, when the control apparatus 28 determines that the superconducting coil 21 has quenched, in other words, when the determination is YES, the processing proceeds to Step ST37. In Step ST37, the control apparatus 28 places the SSR that is the second switch 261 being placed in a closed circuit state in Step ST33 in an open circuit state and returns to the operation in Step ST32. In Step ST35, when the control apparatus 28 determines that the superconducting coil 21 has not quenched, in other words, when the determination is NO, the processing proceeds to Step ST36.

In Step ST36, the control apparatus 28 determines whether the maximum temperature Tmax that is the higher temperature out of the temperatures of the two current leads 24a and 24b is equal to or less than the predetermined circuit-opening condition temperature Ta. When maximum temperature Tmax > circuit-opening condition temperature Ta is satisfied, in other words, when the determination is NO, the processing proceeds to Step ST37. When maximum temperature Tmax ≤ circuit-opening condition temperature Ta is satisfied, in other words, when the determination is YES, the processing proceeds to Step ST38.

In Step ST38, the control apparatus 28 determines whether the excitation current has reached a target value, in other words, a target current. The target value may be a rated value for excitation or may be a current value set for demagnetization or degaussing. When the target current is reached in Step ST38, in other words, when the determination is YES, the processing ends. In other words, when the target current is not reached, in other words, when the determination is NO in Step ST38, the processing proceeds to Step ST34.

### (Modified Example 2 of First Embodiment)

Fig. 9 is a block diagram illustrating an internal configuration example of the superconducting magnet 10 according to Modified Example 2 of the first embodiment. In Modified Example 2 of the first embodiment, the second switch 261 is an SSR. In Modified Example 2 of the first embodiment, the load 272 and the UPS 274 are electrically connected to the superconducting coil 21. In other words, Modified Example 2 of the first embodiment is a case in which the demagnetization is performed while the static magnetic field power source 271 is not electrically connected to the superconducting coil 21.

Modified Example 2 of the first embodiment is different from the first embodiment in that the control apparatus 28 receives an instruction relating to demagnetization and the SSR is placed in a closed circuit state in accordance with the instruction in Modified Example 2 of the first embodiment.

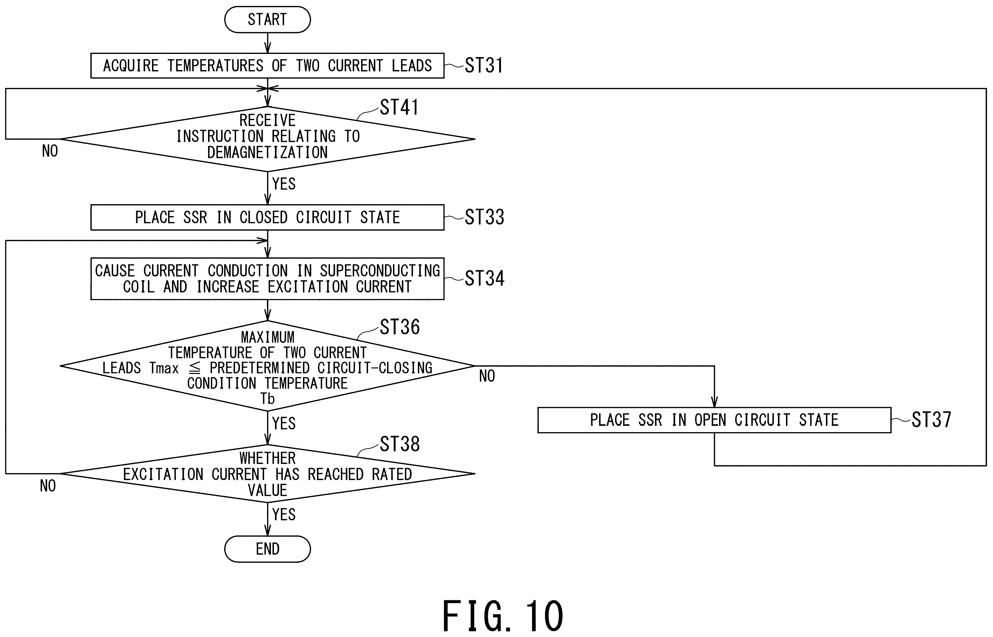

With reference to the flowchart in Fig. 10, an operation example of the MRI apparatus 1 according to Modified Example 2 of the first embodiment is described. Steps ST31, ST33, ST34, ST36, ST37, and ST38 in the flowchart in Fig. 10 (in other words, Modified Example 2 of the first embodiment) are substantially the same as the flowchart in Fig. 8 (in other words, Modified Example 1 of the first embodiment), and hence overlapping description is omitted. In Modified Example 2 of the first embodiment, the processing proceeds to Step ST41 after Step ST31.

In Step ST41, the control apparatus 28 receives an instruction relating to demagnetization. When the instruction is received, the control apparatus 28 performs control for placing the SSR that is the second switch 261 in a closed circuit state in Step ST33 following Step ST41. As a result, it becomes possible to demagnetize the superconducting coil 21 without quenching the superconducting coil 21.

In Step ST41, the control apparatus 28 may receive an instruction relating to demagnetization in accordance with the detection of power outage such as the detection of the activation of the UPS 274 that operates at the time of power outage and the detection of switching from a commercial power to the UPS 274, for example.

In Step ST41, the control apparatus 28 may receive an instruction relating to demagnetization given by a user such as a doctor, a technologist, and service technician via an input interface 43 due to a suction-related accident, for example. An instruction relating to demagnetization via the input interface 43 may be given not only when the UPS 274 in Fig. 9 is electrically connected and may also be given when commercial power is electrically connected.

In Modified Example 2 of the first embodiment, the instruction relating to demagnetization is received in Step ST41, and hence the control apparatus 28 causes current conduction in the superconducting coil 21 and reduces the excitation current in Step ST34. In Step ST38, the target value is a current value set for demagnetization or degaussing.

### (Modified Example 3 of First Embodiment)

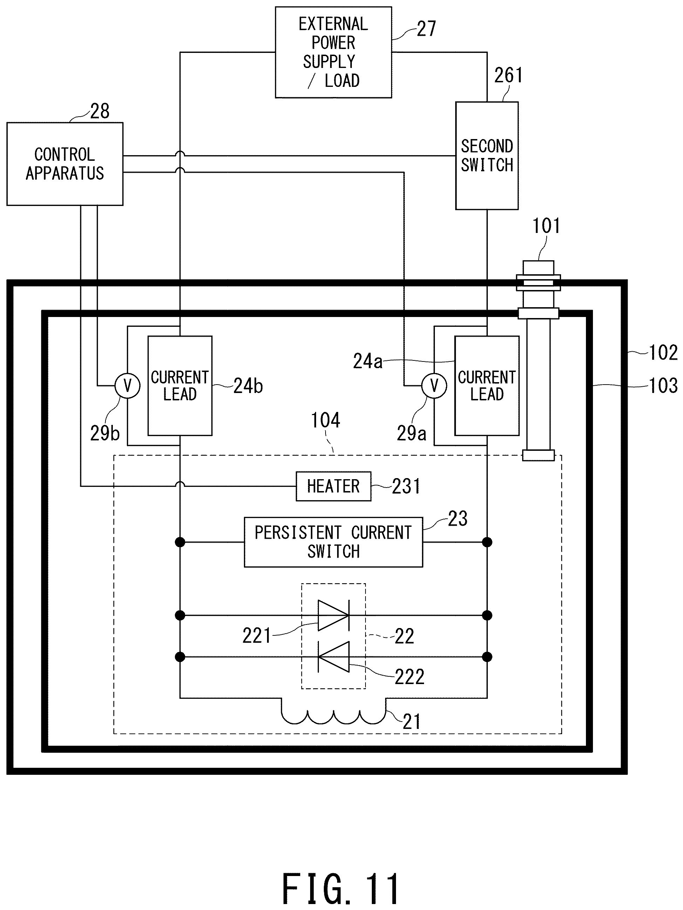

Fig. 11 is a block diagram illustrating an internal configuration example of a superconducting magnet according to Modified Example 3 of the first embodiment. In Modified Example 3 of the first embodiment, the control of the open circuit state and the closed circuit state of the second switch 261 is performed by monitoring the voltage applied to the current leads. Due to this feature, Modified Example 3 of the first embodiment is different from the first embodiment in which the control is performed by monitoring the temperatures of the current leads. Note that the control of the open circuit state and the closed circuit state of the second switch 261 may be performed by monitoring the voltage applied to the current leads in Modified Example 1 and Modified Example 2 of the first embodiment.

In Modified Example 3 of the first embodiment, the MRI apparatus 1 includes at least one of a voltmeter 29a that measures the potential difference across the current lead 24a and a voltmeter 29b that measures the potential difference across the current lead 24b instead of the temperature sensors 25a and 25b or in addition to the temperature sensors 25a and 25b.

The potential difference across the current lead 24a is a difference between the potential at an end portion of the current lead 24a on the higher temperature side, in other words, the external power supply-load unit 27 side, thereof and the potential at an end portion of the current lead 24a on the lower temperature side, in other words, the superconducting coil 21 side, thereof. Similarly, the potential difference across the current lead 24b is a difference between the potential at an end portion of the current lead 24b on the higher temperature side, in other words, the external power supply-load unit 27 side, thereof and the potential at an end portion of the current lead 24b on the lower temperature side, in other words, the superconducting coil 21 side, thereof. The potential differences across the current leads 24a and 24b are an index relating to a potential difference across a current lead. The potential differences across the current leads 24a and 24b may be an index relating to the temperature of a current lead.

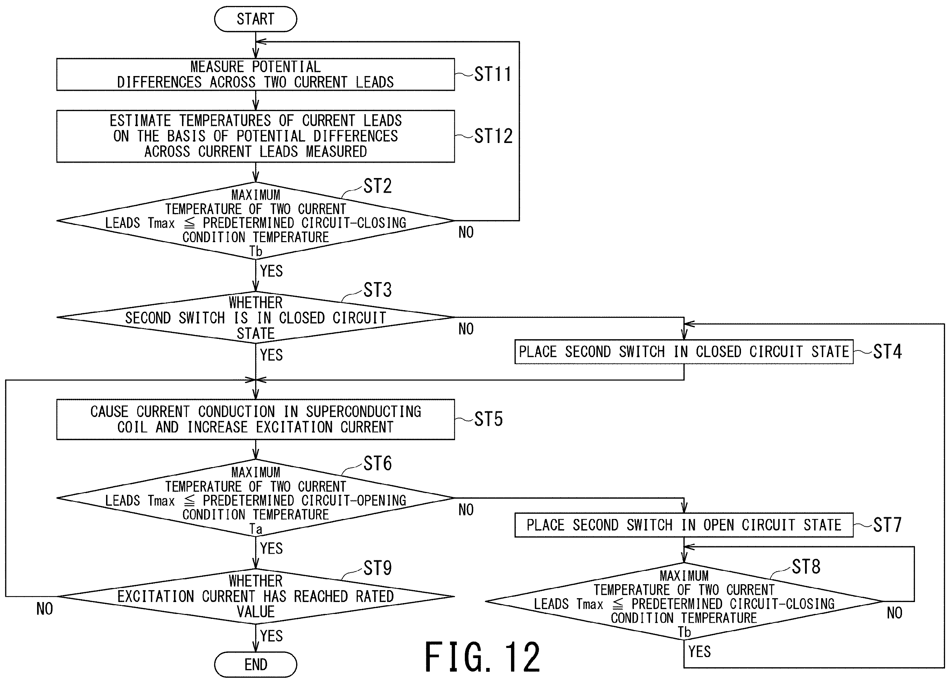

With reference to the flowchart in Fig. 12, an operation example of the MRI apparatus 1 according to Modified Example 3 of the first embodiment is described. In the flowchart in Fig. 12 (in other words, Modified Example 3 of the first embodiment), processing of Steps ST11 and ST12 is executed instead of Step ST1 in the flowchart in Fig. 5 (in other words, the first embodiment). The other steps ST2 to ST9 are substantially the same as those in the flowchart in Fig. 5 (in other words, the first embodiment), and hence overlapping description is omitted.

In Step ST11, the control apparatus 28 measures the potential differences across the two current leads 24a and 24b. In Step ST12, the control apparatus 28 estimates the temperatures of the current leads on the basis of the potential differences across the current leads measured by the voltmeters 29a and 29b. The estimation of the temperatures of the current leads based on the measurement of the potential differences across the two current leads 24a and 24b and the measured potential difference is executed for a predetermined amount of time or continuously, and determination relating to the temperatures of the two current leads 24a and 24b in Steps ST2, ST6, ST8 is enabled.

In the flowchart in Fig. 12, the opening and closing state of the second switch 261 is controlled on the basis of the temperatures of the current leads estimated from the potential difference, but the opening and closing state of the second switch 261 may be controlled on the basis of the change amounts of the temperatures of the current leads estimated from the potential differences.

In other words, the control apparatus 28 places the second switch 261 in an open circuit state or a closed circuit state on the basis of the potential differences across the current leads 24a and 24b measured by the voltmeters 29a and 29b, and the temperatures or the temperature change amounts of the current leads 24a and 24b estimated from the potential differences measured by the voltmeters 29a and 29b. On the basis of any of the potential differences across the current leads 24a and 24b and the temperature and the temperature change amounts of the current leads 24a and 24b, the control apparatus 28 places the second switch 261 in a closed circuit state when the value is equal to or less than a predetermined first condition value and places the second switch 261 in an open circuit state when the value exceeds a predetermined second condition value. Here, the first condition value and the second condition value may be condition values relating to temperature or may be condition values relating to potential difference.

### (Second Embodiment)

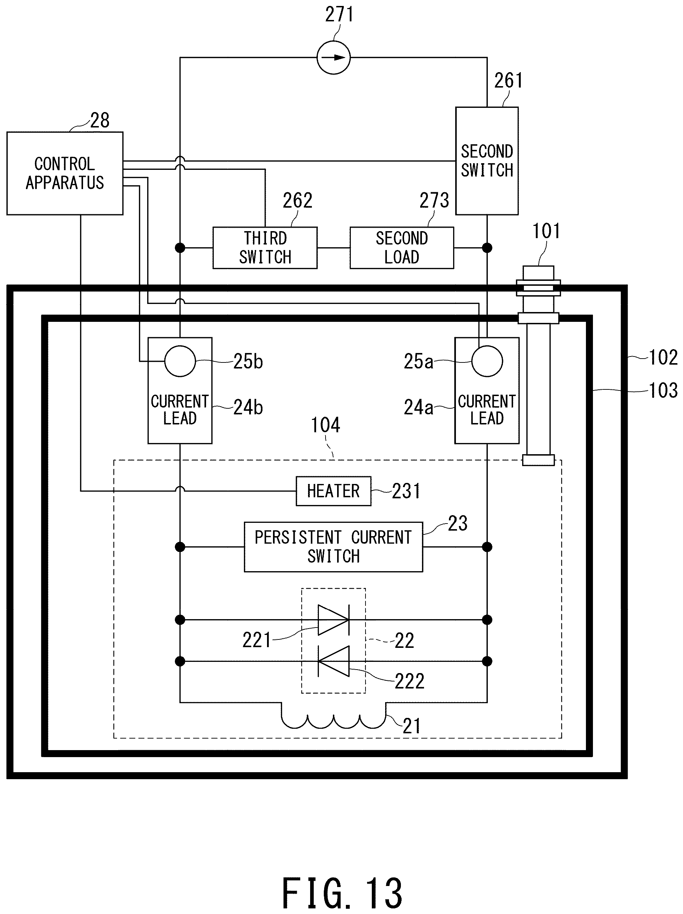

Fig. 13 is a block diagram illustrating an internal configuration example of the superconducting magnet 10 according to a second embodiment. The second embodiment is different from the first embodiment in that a third switch 262 and a second load 273 are further included in the second embodiment. A case in which the second load 273 is a resistor is described below, but the second load 273 may be a diode, and the third switch 262 is not necessarily needed when the second load 273 is a diode.

In the second embodiment, the external power supply-load unit 27 is composed of the static magnetic field power source 271. In this case, the third switch 262 and the second load 273 electrically connected in parallel to the static magnetic field power source 271 are further included between the static magnetic field power source 271 and the two current leads 24a and 24b. The third switch 262 and the second load 273 are connected in series. The third switch 262 mechanically or electrically switches the connection of the electric circuit. In other words, the third switch 262 is configured to be switchable between an electrically connected state and an electrically open state. Regarding the third switch 262, the electrically connected state is also referred to as a closed circuit state, and the electrically open state is also referred to as an open circuit state. The third switch 262 may be a mechanical switch or a semiconductor switch that turns the current ON and OFF.

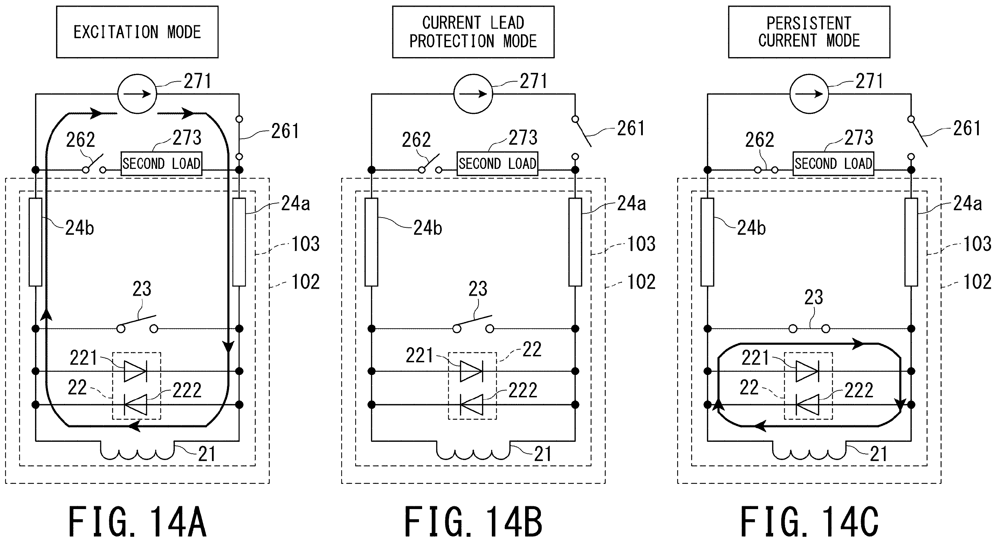

Fig. 14A to Fig. 14C are diagrams for describing the concept of three operation modes in the superconducting magnet 10. Fig. 14A is a diagram illustrating an operation example of an excitation mode.

In the excitation mode of the second embodiment, the second switch 261 is in a closed circuit state, and the third switch 262 is in an open circuit state. In the excitation mode, the persistent current switch 23 is in an open circuit state. In this case, the heater 231 of the persistent current switch 23 is controlled by the control apparatus 28 to be turned ON. In the excitation mode, the excitation current supplied from the static magnetic field power source 271 flows in a current loop of the current lead 24a, the superconducting coil 21, and the current lead 24b. When the excitation current gradually increases from zero and reaches a rated value, the excitation mode transitions to a persistent current mode.

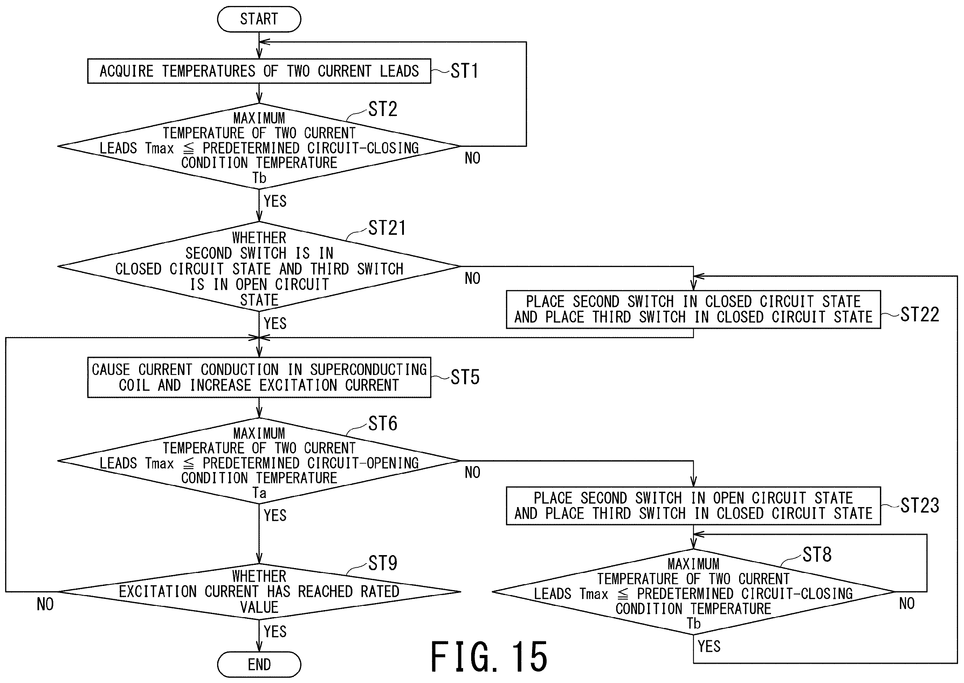

With reference to the flowchart in Fig. 15 and Fig. 14B, an operation example of a current lead protection mode in the excitation process is described. In the flowchart in Fig. 15 (in other words, the second embodiment), processing of Steps ST21, ST22, and ST13 is executed instead of Steps ST3, ST4, and ST7 in the flowchart in Fig. 5 (in other words, the first embodiment). The other steps ST1, ST2, ST5, ST6, ST8, and ST9 are substantially the same as those in the flowchart in Fig. 5 (in other words, the first embodiment), and hence overlapping description is omitted. In the second embodiment, the processing proceeds to Step ST21 after Step ST2.

In Step ST21, the control apparatus 28 determines whether the second switch 261 is in a closed circuit state and the third switch 262 is in an open circuit state. When the second switch 261 is in a closed circuit state and the third switch 262 is in an open circuit state, in other words, when the determination is YES, the processing proceeds to Step ST5. When the second switch 261 is in an open circuit state and the third switch 262 is in a closed circuit state, in other words, when the determination is NO, the processing proceeds to Step ST22.

In Step ST22, the control apparatus 28 places the second switch 261 in a closed circuit state and places the third switch 262 in a closed circuit state. In the second embodiment, the processing proceeds to Step ST5 after Step ST22, and the processing proceeds to Step ST23 after Step ST6.

In Step ST23, the control apparatus 28 places the second switch 261 in an open circuit state and places the third switch 262 in a closed circuit state.

Here, Fig. 14B is a diagram illustrating an operation example of the current lead protection mode in the excitation process. When the second switch 261 is placed in an open circuit state and the third switch 262 is placed in an open circuit state, the current that flows through the two current leads 24a and 24b becomes zero. Even when a current loop is formed by the superconducting coil 21 and the persistent current switch 23 (the persistent current mode illustrated in Fig. 14C), the current that flows through the two current leads 24a and 24b becomes zero. As a result of the current that flows through the two current leads 24a and 24b becoming zero, the temperatures of the current leads 24a and 24b are placed in a reduced or unchanged state. As a result, burnout can be prevented.

Fig. 14C is a diagram illustrating an operation example of the persistent current mode. When the excitation current reaches the rated value, the heater 231 of the persistent current switch 23 is turned OFF by the control apparatus 28. By turning OFF the heater 231, the superconducting member included in the persistent current switch 23 is cooled, the normal conduction state transitions to the superconducting state, and the persistent current switch 23 is placed in a closed circuit state. In the persistent current mode in the second embodiment, the second switch 261 is in an open circuit state and the third switch 262 is in a closed circuit state.

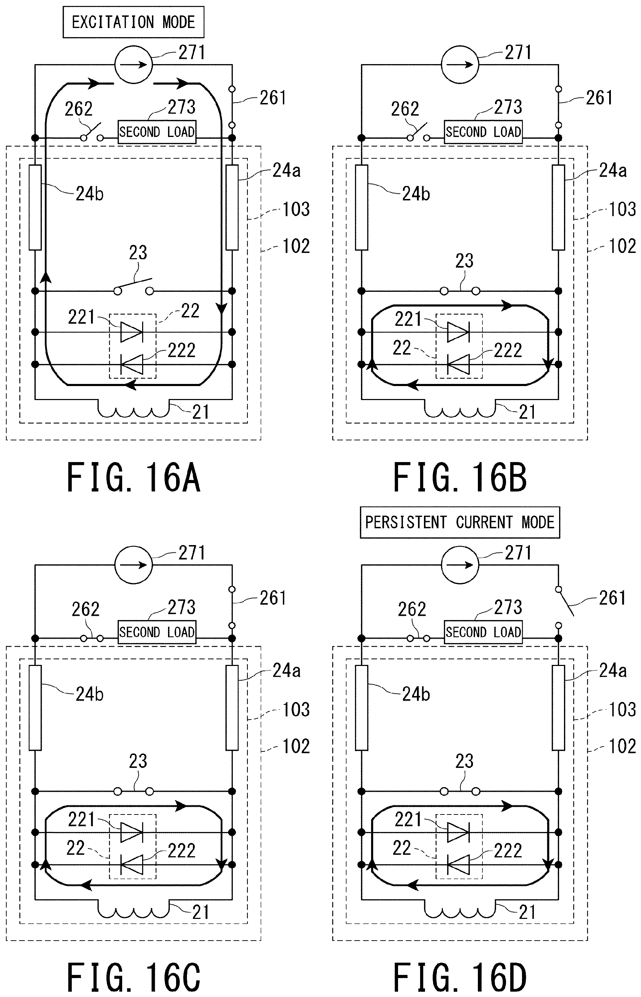

Here, with reference to Fig. 16A to Fig. 16D, switching that transitions from the excitation mode to the persistent current mode is described. In the excitation mode, after the persistent current switch 23 (Fig. 16A) in the open circuit state is switched to a closed circuit state (Fig. 16B), the third switch 262 is switched from an open circuit state to a closed circuit state (Fig. 16C), and the second switch 261 is switched from a closed circuit state to an open circuit state (Fig. 16D). In this case, the control apparatus 28 monitors the opening and closing state of at least one switch out of the second switch 261 and the third switch 262. The control apparatus 28 may further monitor the opening and closing state of the first switch.

In other words, the control apparatus 28 performs control for placing the second switch 261 in a closed circuit state and placing the third switch 262 in an open circuit state in the excitation process of supplying current to the superconducting coil 21. The control apparatus 28 performs control for placing the second switch 261 in an open circuit state and placing the third switch 262 in a closed circuit state after current is supplied to the superconducting coil 21.

As a result, a persistent current loop is formed by the persistent current switch 23 and the superconducting coil 21, and persistent current flows through the superconducting coil 21. Both the superconducting coil 21 and the persistent current switch 23 are in a superconducting state, and the electrical resistance is zero. Therefore, even when the static magnetic field power supply 271 is removed from the superconducting magnet 10, a persistent current mode in which the persistent current maintains a persistent current loop is obtained.

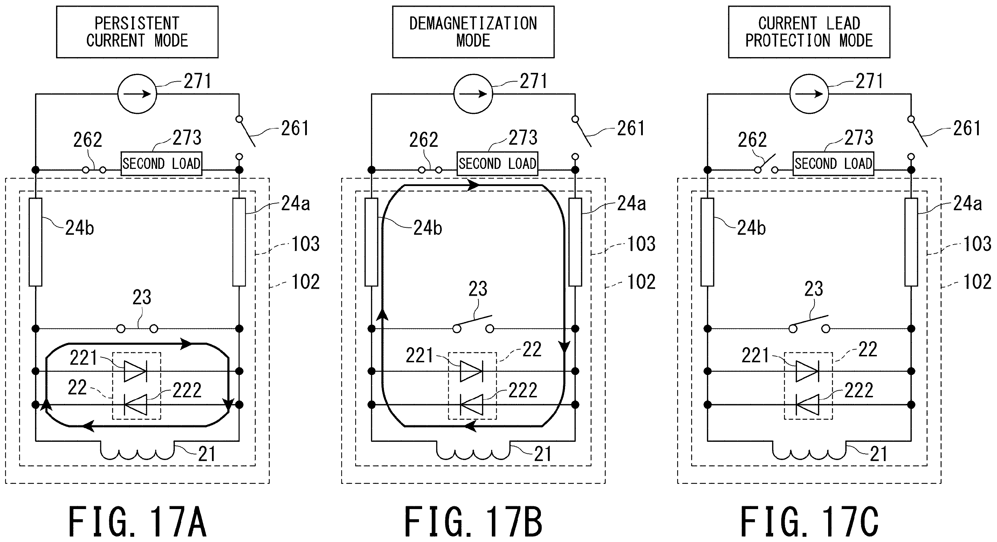

Fig. 17A to Fig. 17C are diagrams for describing the concept of three operation modes in the superconducting magnet 10. Fig. 17A is a diagram illustrating an operation example of the persistent current mode and is the same as Fig. 14C.

Fig. 17B is a diagram illustrating an operation example of a demagnetization mode. In the demagnetization mode in the second embodiment, the second switch 261 is in an open circuit state, and the third switch 262 is in a closed circuit state. In the demagnetization mode, the persistent current switch 23 is in a closed circuit state. In this case, the heater 231 of the persistent current switch 23 is controlled by the control apparatus 28 to be turned OFF. In the demagnetization mode, demagnetizing current of which power source is magnetic energy accumulated in the superconducting coil 21 flows in a current loop of the current lead 24b, the second load 273, and the current lead 24a. Electric power by magnetic energy accumulated in the superconducting coil 21 is consumed by the second load 273, and the magnetic field generated by the superconducting magnet 10 is reduced.

Fig. 17C is a diagram illustrating an operation example of the current lead protection mode in the demagnetization process. The MRI apparatus 1 performs an operation similar to that in the flowchart in Fig. 15 in the demagnetization process as well. When the second switch 261 is placed in an open circuit state and the third switch 262 is placed in an open circuit state, the current that flows through the two current leads 24a and 24b becomes zero. Even when a current loop is formed by the superconducting coil 21 and the persistent current switch 23, the current that flows through the two current leads 24a and 24b becomes zero. As a result of the current that flows through the two current leads 24a and 24b becoming zero, the temperatures of the current leads 24a and 24b are placed in a reduced or unchanged state. As a result, burnout can be prevented.

As above, according to the MRI apparatus 1 according to the embodiment, when the temperature of the current lead becomes equal to or more than a predetermined value, in order to prevent the burnout of the current lead, the switch disposed between the current lead and the static magnetic field power source or the switch disposed between the current lead and the load is opened, and the circuit with the static magnetic field power source and/or the load is cut off. As a result, the current that flows through the current lead becomes zero. As a result, the temperature of the current lead decreases, and the burnout of the current lead can be prevented.

According to at least one embodiment described above, a current lead used in a helium-free superconducting magnet can be protected.

In the above embodiments, the term "processor" means, for example, circuitry such as a dedicated or general-purpose central processing unit (CPU), a graphics processing unit (GPU), an application specific integrated circuit (ASIC), or a programmable logic device (for example, a simple programmable logic device (SPLD), a complex programmable logic device (CPLD), or a field programmable gate array (FPGA)).

When the processor is, for example, a CPU, the processor reads and executes a program stored in storage circuitry to implement various functions. When the processor is, for example, an ASIC, a function corresponding to the program is directly incorporated as logic circuitry in circuitry of the processor instead of the processor storing the program in the storage circuit. In this case, the processor implements various functions by hardware processing of reading and executing the program incorporated in the circuitry, or the processor can also implement various functions by combining software processing and hardware processing.

In the embodiments described above, the example is described in which the single processor of the processing circuitry implements the functions. However, the processing circuitry may be configured by combining a plurality of independent processors, and the processors may implement the respective functions. In a case where the plurality of processors is provided, the storage circuitry that stores the programs may be provided individually for each processor, or one piece of storage circuitry may collectively store the programs corresponding to the functions of all the processors.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims are intended to cover such forms or modifications as would fall within the scope and spirit of the inventions.

## Claims

1. A superconducting magnet, comprising:
a superconducting coil configured to generate a static magnetic field;
a persistent current switch or a first switch, the persistent current switch being electrically connected to the superconducting coil and being configured to perform switching between a superconducting state and a normal conduction state, the first switch being electrically connected to the superconducting coil and being configured to mechanically or electrically open and close an electric circuit;
at least one of an external power supply and a load, the external power supply being configured to supply current to the superconducting coil, the load being configured to dump magnetic energy of the superconducting coil;
a current lead configured to electrically connect the superconducting coil and any one of the external power supply, the load, or both the external power supply and the load to each other;
a second switch provided between the superconducting coil and the any one of the external power supply, the load, or both the external power supply and the load and being configured to include a first state and a second state,
wherein the first state is a state in which the superconducting coil and the any one of the external power supply, the load, or both the external power supply and the load are electrically connected to each other, and
the second state is a state in which electrical connection between the superconducting coil and the any one of the external power supply, the load, or both the external power supply and the load is cut off; and
a control apparatus configured to switch the second switch between the first state and the second state.

2. The superconducting magnet according to claim 1, wherein the current lead is configured to include a high-temperature superconducting material or phosphorous-deoxidized copper.

3. The superconducting magnet according to claims 1 or 2, wherein the control apparatus is configured to switch the second switch between the first state and the second state based on an index relating to a temperature of the current lead.

4. The superconducting magnet according to claims 3,
wherein the current lead includes a first current lead and a second current lead,
the first current lead and the second current lead are electrically connected to both ends of the superconducting coil, respectively,
a first circuit and a second circuit that electrically connect the first current lead and the second current lead to each other are electrically connected in parallel to each other,
the first circuit includes the external power supply,
the second circuit includes a third switch and a second load,
the third switch includes an electrically connected state and an electrically open state, and
the third switch and the second load are connected in series within the second circuit.

5. The superconducting magnet according to claim 4, wherein the control apparatus is configured to place the second switch in the first state and place the third switch in an electrically open state in a process of supplying current to the superconducting coil.

6. The superconducting magnet according to claims 4 or 5, wherein the control apparatus is configured to place the second switch in the second state and place the third switch in an electrically connected state after a process of supplying current to the superconducting coil is completed.

7. The superconducting magnet according to any one of claims 3 to 6, further comprising at least one sensor,
the at least one sensor being configured to measure a temperature of at least one of the current leads, wherein the index relating to the temperature of the current lead is the temperature of the current lead measured by the sensor.

8. The superconducting magnet according to claim 7,
wherein the control apparatus is configured to;
place the second switch in the first state when the index relating to the temperature of the current lead is equal to or less than a first condition value, and
place the second switch in the second state when the index relating to the temperature of the current lead is more than a second condition value,
wherein the second condition value is equal to or more than the first condition value.

9. The superconducting magnet according to any one of claims 3 to 6, further comprising at least one voltmeter,
the at least one voltmeter being configured to measure a potential difference across at least one of the current leads, wherein the index relating to the temperature of the current lead is the temperature of the current lead estimated based on the potential difference.

10. The superconducting magnet according to claims 1 or 2, further comprising at least one voltmeter, wherein;
the at least one voltmeter is configured to measure a potential difference across at least one of the current leads, and
the control apparatus is configured to switch the second switch between the first state and the second state based on an index relating to the potential difference across the current lead.

11. The superconducting magnet according to claim 10,
wherein the control apparatus is configured to;
place the second switch in the first state when the index relating to the potential difference across the current lead is equal to or less than a first condition value, and
place the second switch in the second state when the index relating to the potential difference across the current lead is more than a second condition value,
wherein second condition value is equal to or more than the first condition value.

12. The superconducting magnet according to claims 10 or 11, wherein the voltmeter is configured to measure a potential difference across the current lead, the potential difference being a difference between a potential at an end portion of the current lead on a higher temperature side of the current lead and a potential at an end portion of the current lead on a lower temperature side of the current lead.

13. The superconducting magnet according to any one of claims 1 to 12, wherein the second switch is disposed on both ends of the any one of the external power supply, the load, or both the external power supply and the load.

14. The superconducting magnet according to any one of claims 1 to 13, further comprising at least one resistor or at least one pair of bidirectionally disposed diodes electrically connected in parallel with the superconducting coil and the persistent current switch.

15. A magnetic resonance imaging apparatus comprising a superconducting magnet,
wherein the superconducting magnet includes:
a superconducting coil configured to generate a static magnetic field,
a persistent current switch or a first switch, the persistent current switch being electrically connected to the superconducting coil and being configured to perform switching between a superconducting state and a normal conduction state, the first switch being electrically connected to the superconducting coil and being configured to mechanically or electrically open and close a circuit,
at least one of an external power supply and a load, the external power supply being configured to supply current to the superconducting coil, the load being configured to dump magnetic energy of the superconducting coil,
a current lead configured to electrically connect the superconducting coil and any one of the external power supply, the load, or both the external power supply and the load to each other,
a second switch provided between the superconducting coil and any one of the external power supply, the load, or both the external power supply and the load and being configured to include a first state and a second state,
wherein the first state is a state in which the superconducting coil and the any one of the external power supply, the load, or both the external power supply and the load are electrically connected to each other, and
the second state is a state in which electrical connection between the superconducting coil and the any one of the external power supply, the load, or both the external power supply and the load is cut off, and
a control apparatus configured to switch the second switch between the first state and the second state.
